# EUROPEAN PATENT APPLICATION

(11) **EP 2 902 534 A1**
(43) Date of publication of application: **05.08.2015**
(21) Application number: 14153758.9
(22) Date of filing: 04.02.2014
(51) Int. Cl.: C30B 11/00, C30B 15/10, C30B 29/20, C30B 35/00, C01B 31/00, C08K 3/04

(54) **Metal coated crucible for sapphire single crystal growth**

(71) Applicant: SGL Carbon SE, 65201 Wiesbaden (DE)
(72) Inventor: Chen, Kevin, 86405 Meitingen (DE); Taetz, Timo, 86405 Meitingen (DE)

(57) **Abstract**

The invention is related to a crucible precursor (12) for the manufacture of a crucible (10) for single crystal growth composed of graphite as well as related to a crucible (10) for single crystal growth, with a crucible precursor (12) having an outer wall (12a) and an inner wall (12b), and a refractory metal coating (14) coating at least a part of the inner wall (12b) of the crucible precursor (12). Also disclosed is a method for manufacture the crucible (10) comprising the steps: providing a crucible precursor (12), and coating the inner wall (12b) of the crucible precursor (12) with a refractory metal coating (14).

## Description

The present invention relates to a crucible precursor and a crucible thereof for producing single crystals as well as to a method for manufacturing the crucible. Sapphire single crystals are preferred.

In recent years interest into sapphire (α-Al₂O₃) single crystal growth has risen dramatically, mainly due to the growing demand for sapphire wafers as substrates in GaN based LED chip manufacturing.

In order to enable a cost effective production of sapphire wafers, many new technologies and process improvements have been proposed.

In EP 2 278 050 A1 a method and equipment for producing a sapphire single crystal is disclosed.

WO 2013/020153 A1 discloses a crucible for growing sapphire single crystals made of a base crucible and an interior lining. Both, the base crucible and the lining are made of tungsten, molybdenum, rhenium or an alloy of these materials. The interior lining comprises two sections formed by separate components. The first section covers the bottom area, the second section covers the wall area of the base crucible.

A further crucible for the production of sapphire single crystals is disclosed in DE 10 2008 060 520 A1. The crucible disclosed therein consists of a remaining part and a refractory metal layer arranged on the remaining part. The remaining part can be made of a refractory metal or a ceramic material such as Al₂O₃, ZrO₂, Y₂O₃ and MgO.

However, there is still a further need for crucibles that are cost effective in the production.

Therefore, it is an object of the present invention to provide a crucible for single crystal growth that reduces the manufacturing costs of such a crucible.

This object is solved with a crucible precursor with the features of claim 1, a crucible for single crystal growth with the features of claim 5 and a method for manufacturing the crucible according to claim 12. Further preferred embodiments are given by the following description. One or several features of the claims, the description or the figures can be linked with one or several other features thereof to form further preferred embodiments. In particular, one or several features of the independent claims can be replaced with one or several other features of the description. The proposed claims are only considered as a concept to draft the subject-matter without limiting it.

The crucible precursor for the manufacture of a crucible for single crystal growth is composed of graphite. A sapphire single crystal growth is preferred. Graphite is a modification of carbon and provides a lot of advantages. Since graphite does not provide a melting point, the main advantages of graphite are the high corrosion resistance and the high temperature resistance. A further advantage is the electrical and thermal conductivity. Due to the high thermal conductivities, the crucible precursor provides a more homogeneous temperature distribution.

In a preferred embodiment, the crucible precursor has a pot-like shape. Typically, the crucible precursor has an outer diameter of 400 mm. Larger or smaller diameters are possible. For example a larger crucible has an outer diameter of 450 mm, a smaller an outer diameter of 60 mm. Depending on the diameter size, crucible precursors can consist of at least two or more single parts, for instance three parts.

Preferably, the graphite consists of synthetic fine-grain graphite. The grain size of the fine-grain graphite for the manufacturing of the crucible precursor is preferably in the range of 1 - 50 µm, preferably 5 - 25 µm, measured according to DIN ISO 13320:2009. The fine-grain graphite is an isostatically pressed graphite, i.e. a graphite equally pressured or molded from every side, respectively. The main features of isostatic graphite are high strength, high density and an isotropic structure. Preferably, the used isostatic graphite provides a high purity degree with impurities less than 20 ppm, preferably less than 5 ppm. Said values refers generally to the whole amount of impurities.

According to a preferred embodiment, the synthetic fine-grain graphite has a density in the range of 1.50 - 1.95 g/cm³, preferably in the range of 1.70 - 1.90 g/cm³. In further preferred embodiments the synthetic fine-grain graphite has a density of 1.73 g/cm³, preferably 1.77 g/cm³, more preferably 1.83 g/cm³.

In a further preferred embodiment, the synthetic fine-grain graphite has a thermal conductivity in the range of 50 - 150 W/mK, preferably in the range of 80 - 120 W/mK.

The subject matter of the present invention is also a crucible for single crystal growth wherein a sapphire single crystal growth is preferred, with a crucible precursor composed of graphite having an outer wall and an inner wall, and a refractory metal coating coating at least a part of the inner wall of the crucible precursor. The term inner wall encompasses the complete inner surface of the crucible precursor, i.e. the surface that can be in contact with the melt. In a preferred embodiment the graphite has a thermal expansion coefficient in the range of 2.0 * 10⁻⁶ to 8.0 * 10⁻⁶ K⁻¹, preferably in the range of 4.0 * 10⁻⁶ to 5.0 * 10⁻⁶ K⁻¹, more preferably in the range of 2.5 * 10⁻⁶ to 4.0 * 10⁻⁶ K⁻¹, measured in the temperature range of 20 °C - 200 °C, and the refractory metal coating has a thermal expansion coefficient in the range of 4.5 * 10⁻⁶ to 6.5 * 10⁻⁶ K⁻¹. In a further preferred embodiment the graphite has a thermal expansion coefficient of 2.7 * 10⁻⁶ K⁻¹, preferably of 3.9 * 10⁻⁶ K⁻¹, more preferably of 3.9 * 10⁻⁶ K⁻¹, measured in the temperature range of 20 °C - 200 °C. In a further preferred embodiment, the thermal expansion coefficients of graphite and the refractory metal provides a ratio of graphite to metal in the range of 1:3.5 to 2:1, preferably in the range of 1:1.7 to 1.2:1, more preferably in the range of 1:2.6 to 0.8:1. Generally both materials, i.e. the graphite and the refractory metal have to be chosen in a way to accommodate the thermal expansion so that stresses in the coating which leads to delamination, i.e. defects in the coating, are minimized. Surprisingly it has been shown that despite of differences of the thermal expansion coefficients between the graphite and refractory metal, the coating exhibit no delamination or flaking. It is assumed that the pore structure of the graphite crucible improves the bond between graphite and refractory metal. In a further preferred embodiment the refractory metal coating is rigidly connected to the crucible precursor. In an alternative embodiment, the subject-matter can also be combined with features relating to the crucible precursor, which has been already disclosed above.

Typically, the crystal adheres to the refractory metal coating during the growth process of the crystal. In such cases, the crystal has to be separated mechanically from the crucible. As a result, impurities remain as melt residues in the crucible or on the coating, respectively, so that the crucible must be cleaned extensively before reusing. Therefore, the refractory metal coating provides preferably a surface roughness of <1,2 µm, preferably <1 µm and more preferably <0,8 µm according to DIN EN ISO 4288: "Geometrische Produktspezifikationen (GPS) Oberflächenbeschaffenheit: Tastverfahren" German Issue EN ISO 4288:1997. Such a smooth surface, allows an ease withdraw of the manufactured crystal without leading damages on the coating surface.

Preferably the inner wall is completely covered with the refractory metal coating so that the coating ensures a complete sealing of the inner wall of the crucible precursor.

According to a preferred embodiment, the refractory metal coating comprises an outer section and an inner section, wherein the inner section is arranged between the outer section and the inner wall of the crucible precursor. For instance, the inner section can act as a buffer to compensate the different thermal expansions of the crucible precursor and refractory metal coating. The inner section can also be used to impart a better adherence of the refractory metal coating to the inner wall of the crucible precursor.

The outer section of the refractory metal layer consists preferably of a single refractory metal. Preferably the degree of purity is >99 %, more preferably >99,9 %. Such high purity degrees minimize the contamination of the single crystals by the crucible during the manufacturing process, wherein sapphire single crystals are preferred.

The inner section comprises preferably at least one refractory metal layer consisting of a refractory metal different from the outer section. That means that the inner section can be composed of only one single refractory metal or alternatively, is an assembly of different single layers, i.e. the refractory metal layers. Using a multiple layer assembly allows introducing different properties to the coating. For instance, one of the layers can have the function to allow a replacement of the refractory metal coating. In contrast to the outer section, the different layers of the inner section can be composed of a less pure material, i.e. the refractory metal.

According to a preferred embodiment the refractory metal is selected from the group of tungsten, molybdenum, hafnium, niobium, tantalum, ruthenium, rhenium, osmium, iridium or of an alloy thereof. Preferred alloys are tungsten-molybdenum, tungsten-rhenium, molybdenum-rhenium or tungsten-molybdenum-rhenium. The refractory metal or alloy for the refractory metal coating is chosen to withstand corrosion by the molten Al₂O₃ (2050 °C).

The refractory metal coating of the crucible according to the present invention has a preferred thickness in the range of from 1 µm - 1000 µm, preferably 5 µm - 500 µm, more preferably 10 µm - 100 µm. The thickness depends of the specific process parameters of the crystal growth apparatus used and on the coating technology used for applying the metal coating. The thickness of the coating has to be chosen so as to ensure an undergoing chemical reaction during the crystal growth process.

In an alternative embodiment, the refractory metal coating is removable so that the refractory metal coating can be removed from the crucible precursor after the manufacturing process of the single crystal, wherein sapphire single crystals are preferred. In this way, the crucible precursor can be used several times. Simply overturning or toppling the crucible can leads to the removal of the crystal together with the refractory metal coating. Alternatively, the crucible precursor can be burned of the refractory metal coating in an oxygen atmosphere. It is also possible to etch or to burn the refractory metal layer to remove the refractory metal coating. A refractory metal coating can be etched with hydrochloric acid. In a preferred embodiment, the refractory metal layer melts at the working temperature of 2050 °C so that the remaining refractory metal coating can be pulled out of the crucible precursor together with the crystal, for instance using an appropriate plier.

The subject matter of the present invention further comprises a method for manufacture the crucible according to the invention comprising providing the crucible precursor according to the invention and coating the inner wall of the crucible precursor with a refractory metal coating. In an alternative embodiment, the subject-matter can be also combined with features relating to the crucible precursor or the crucible, respectively, which has been already disclosed above.

The refractory metal coating is preferably applied to the crucible precursor using a deposition process. The person skilled in the art knows several techniques like Chemical Vapor Deposition (CVD), Physical Vapor Deposition (PVD), Vacuum Plasma Spraying (VPS), Sputtering or Electro-Plating. Another techniques known by the person skilled in the art, preferably those producing coatings of molybdenum, tungsten or a molybdenum tungsten alloy in the range of 10 - 50 µm, preferably in the range of 10 - 25 µm, are preferred. Alternatively or complementary, the refractory metal coating is applied by galvanizing. Alternatively or complementary, the refractory metal coating can be manufactured separately using cold forming methods, such as turning on a lathe, deep drawing, pressing or pulling on a negative and subsequently put the cold formed refractory metal coating into the crucible precursor. It is necessary that the refractory metal coating is leak-tight, i.e. hermetically sealed.

A further subject matter of the present invention is a single crystal growing method using the crucible according to the present invention, preferably a sapphire crystal growing method.

In the following, a detailed description of the invention with reference to the drawings and examples is described. Those features are not limited to the respective figures or examples, respectively. Hence, one or several features disclosed therein can be rather linked with one or several features disclosed in other figures, examples or the above description to form further preferred embodiments. Furthermore, the following description only exemplifies the shown features as well as the interaction thereof without limiting the extent of protection of the subject-matter.
Figure 1 shows a sectional view of a first embodiment of the crucible according to the present invention, and
Figure 2 shows a sectional view of a part of a second embodiment of the crucible according to the present invention.

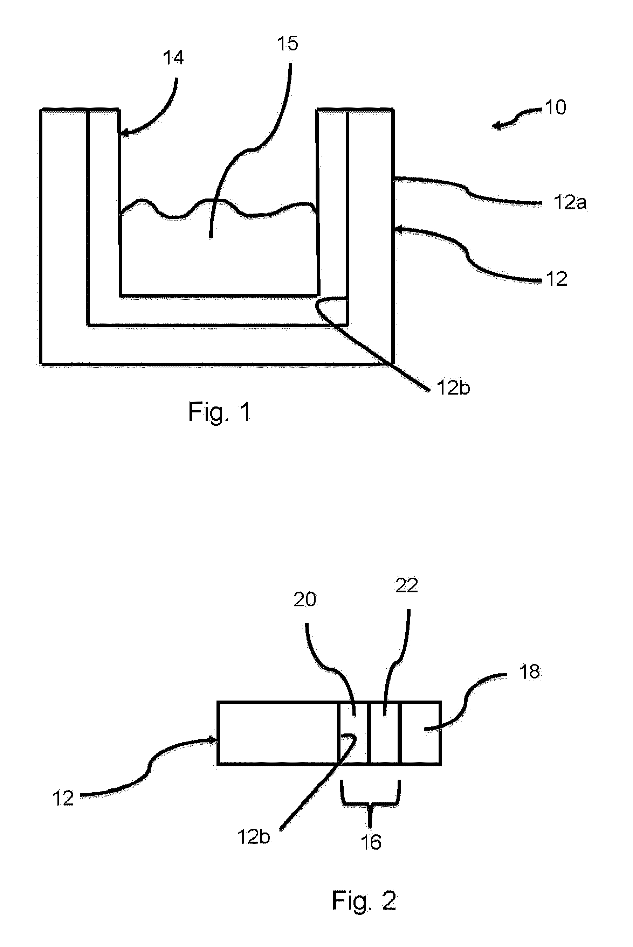

Fig. 1 is a sectional view of a first embodiment of the crucible according to the present invention. The crucible 10 provides a pot-like shaped crucible precursor 12. The crucible precursor 12 has an outer wall 12a and an inner wall 12b. The inner wall 12b is coated with a refractory metal coating 14, for example tungsten. The crucible 10 contains a melt 15 of Al₂O₃. As can be seen in figure 1, the melt 15 is only in contact with the refractory metal coating 14 so that the inner wall 12b of the crucible precursor is protected from contact with the melt 15.

Fig. 2 is a sectional view of a part of a second embodiment of the crucible 10. The refractory metal coating 14 coats the inner wall 12b of the crucible precursor 12 and provides an outer section 18 and an inner section 16. The outer section 18 is in direct contact with the melt 15 (not shown), and can be composed of for example tungsten. The inner section 16 is arranged between the inner wall 12b and the outer section 18. The inner section 16 can provide at least one refractory metal layer 20. The inner section 16 can also provide a further refractory metal layer 22.

### Examples

Crucible precursors made of different kinds of graphite were used. Graphite 1 is an isostatically molded graphite with a density of 1.73 g/cm³ and a thermal expansion coefficient of 2.7 * 10⁻⁶ K⁻¹. Graphite 2 is an isostatically molded graphite with a density of 1.77 g/cm³ and a thermal expansion coefficient of 3.9 * 10⁻⁶ K⁻¹. Graphite 3 is an isostatically molded graphite with a density of 1.83 g/cm³ and a thermal expansion coefficient of 4.0 * 10⁻⁶ K⁻¹. The different crucible precursors were coated using an appropriate technique. In one run two different coatings were deposited. First a thin molybdenum coating was deposited on the crucible precursor to form the inner section. Subsequently, the thicker tungsten metal coating (outer section) was deposited. Obtained coated crucibles were heat treated. The heat treatment was performed in a 5 mbar nitrogen atmosphere. The crucible was heat up within a 2 h period from room temperature (RT) to 2200 °C. The crucible was subsequently heated 2 h at 2200 °C. In a next step the crucible was cooled to RT in said atmosphere. The cooling procedure takes approximately 6 h. The heat procedure was repeated once. No flaking or delamination of the refractory metal coating could be detected.

| | | | | | | |
|---|---|---|---|---|---|---|
| Graphite | 1 | 1 | 2 | 2 | 3 | 3 |
| Coating [µm] | 20 | 10 | 20 | 10 | 20 | 10 |
| Metal | W-Mo | W-Mo | W-Mo | W-Mo | W-Mo | W-Mo |

## Claims

1. A crucible precursor (12) for the manufacture of a crucible (10) for single crystal growth composed of graphite.

2. The precursor (12) of claim 1, wherein the graphite consists of synthetic fine-grain graphite.

3. The precursor (12) of claim 2, wherein the synthetic fine-grain graphite has a density of 1.75 to 1.95 g/cm³.

4. The precursor of claim 2 or 3, wherein the synthetic fine-grain graphite has a thermal conductivity in the range of 50 - 150 W/mK, preferably in the range of 80 - 120 W/mK.

5. A crucible (10) for single crystal growth, with
- the crucible precursor (12) of anyone of claims 1 - 4 having an outer wall (12a) and an inner wall (12b), and
- a refractory metal coating (14) coating at least a part of the inner wall (12b) of the crucible precursor (12).

6. The crucible (10) of claim 5, wherein the refractory metal coating (14) comprises an outer section (18) and an inner section (16) arranged between the outer section (18) and the inner wall (12b) of the crucible precursor (12).

7. The crucible (10) of claim 5 or 6, wherein the outer section (18) consists of a single refractory metal.

8. The crucible (10) of anyone of claim 5 to 6, wherein the inner section (16) comprises at least one refractory metal layer (20) consisting of a refractory metal different from the outer section (18).

9. The crucible (10) of anyone of claims 5 to 8, wherein the refractory metal is selected from the group of tungsten, molybdenum, hafnium, niobium, tantalum, ruthenium, rhenium, osmium, iridium or of an alloy thereof.

10. The crucible (10) of anyone of claims 5 to 9, wherein the refractory metal coating (14) has a thickness in the range of from 1 µm - 1000 µm, preferably 5 µm - 500 µm, more preferably 10 µm - 100µm.

11. The crucible (10) of anyone of claims 5 to 10, wherein the refractory metal coating (14) is removable.

12. Method for manufacture the crucible (10) of anyone of claims 5 to 11 comprising the steps:
- providing a crucible precursor (12) of anyone of claims 1 to 4, and
- coating the inner wall (12b) of the crucible precursor (12) with a refractory metal coating (14).

13. The method of claim 12, wherein the refractory metal coating (14) is applied to the crucible precursor (12) using a deposition process.

14. A single crystal growing method using the crucible (10) of any one of claims 5 to 13.

15. The method of claim 14, wherein the method is a sapphire single crystal growing method.
